# EUROPEAN PATENT APPLICATION

(11) **EP 4 040 234 A1**
(43) Date of publication of application: **10.08.2022**
(21) Application number: 21155372.2
(22) Date of filing: 05.02.2021
(51) Int. Cl.: G03F 7/20

(54) **A METHOD AND SYSTEM FOR PREDICTING ABERRATIONS IN A PROJECTION SYSTEM**

(71) Applicant: ASML Netherlands B.V., 5500 AH Veldhoven (NL)
(72) Inventor: VAN DE WAL, Marinus, Maria, Johannes, 5500 AH Veldhoven (NL); VAN BERKEL, Koos, 5500 AH Veldhoven (NL); DOLK, Victor, Sebastiaan, 5500 AH Veldhoven (NL); SCHNEIDERS, Mauritius, Gerardus, Elisabeth, 5500 AH Veldhoven (NL); KOEVOETS, Adrianus, Hendrik, 5500 AH Veldhoven (NL)
(74) Representative: ASML Netherlands B.V.

(57) **Abstract**

A method of predicting thermally induced aberrations of a projection system for projecting a radiation beam, the method comprising: calculating an irradiance profile for at least one optical element of the projection system from a power and illumination source pupil of the radiation beam, estimating a temperature distribution as a function of time in the at least one optical element of the projection system using the calculated irradiance profile for the at least one optical element of the projection system; calculating the thermally induced aberrations of the projection system based on the estimated temperature distribution and a thermal expansion parameter map associated with the at least one optical element of the projection system, wherein the thermal expansion parameter map is a spatial map indicating spatial variations of thermal expansion parameters in the at least one optical element of the projection system or a uniform map.

## Description

### FIELD

The present invention relates to a method and system for predicting aberrations in a projection system. More particularly, the method relates to modelling projection system heating that result in thermally induced aberrations.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The projection system which is used to image the pattern from a patterning device onto the substrate will induce some aberrations in the wavefront of the projected image.

During the projection of the pattern onto the substrate, the projection system will heat up, and this will cause the imaging properties (e.g. the wavefronts) of the projection system to drift. In EUV lithography, this phenomenon is called mirror heating.

Although mirrors in the projection system are optimized for EUV radiation transmission, a significant part of EUV (but also out-of-band) energy is absorbed in the mirrors and transformed into heat. This heating causes thermal stresses in the material of the mirrors leading to deformations of the optical surfaces. These deformations finally cause aberrations in the projection system causing imaging errors.

It is an object of the invention to provide a method for predicting and modelling aberrations which obviates or mitigates one or more problems associated with the prior art.

### SUMMARY

According to a first aspect of the invention, there is provided a method of predicting thermally induced aberrations of a projection system for projecting a radiation beam, the method comprising: calculating an irradiance profile for at least one optical element of the projection system from a power and illumination source pupil of the radiation beam, estimating a temperature distribution as a function of time in the at least one optical element of the projection system using the calculated irradiance profile for the at least one optical element of the projection system; and calculating the thermally induced aberrations of the projection system based on the estimated temperature distribution and a thermal expansion parameter map associated with the at least one optical element of the projection system, wherein the thermal parameter map is a spatial map indicating spatial variations of thermal expansion parameters in the at least one optical element of the projection system or a uniform map.

This may have an advantage that the accuracy of the prediction of thermally induced optical aberrations in a lithographic apparatus may be increased. This may improve imaging, overlay and focus performance. Furthermore, calibration may not be required after each customer application, thereby increasing productivity.

The irradiance profile may provide a (diffraction based) estimate of the heat load on the at least one optical element of the projection system.

The irradiance profile for the at least one optical element may be calculated using an optical model.

The method may comprise estimating the temperature distribution in the at least one optical element using a thermal model.

This may be considered to be physical modelling (as opposed to black box or machine learning modelling).

The method may further comprise calculating the irradiance profile using a diffracted pattern of the radiation beam at a patterning device, the projection system projecting radiation from the patterning device.

The method may further comprise calculating the diffracted pattern using the power of the radiation beam, the illumination source pupil of the radiation beam and a characterization of the patterning device.

The characterization of the patterning device may be the pattern of the patterning device. The patterning device pattern may comprise a plurality of patterns in case of multiple relevant wavelengths, e.g. EUV and IR, and these can change as a function of time, i.e., by switching masks, changing illumination pupils, and on-/off switching of the EUV.

The method may further comprise calculating the diffracted pattern using an optical model based on first principles.

The method may further comprise calculating the temperature distribution using linear or non-linear differential equations.

The linear differential equations may include high-order thermal dynamics.

The method may further comprise estimating the temperature distribution using a thermal dynamic model based on first principles.

The method may further comprise calculating the thermally induced aberrations using a static non-linear function, calculating structural strain in the at least one optical element of the projection system from the estimated temperature distribution, calculating the thermally induced aberrations of the projection system based on the calculated structural strain in the at least one optical element of the projection system, calculating structural deformation of the at least one optical element of the projection system using the calculated structural strain and calculating the thermally induced aberrations of the projection system using the calculated structural deformation of the at least one optical element of the projection system, and calculating the thermally induced aberrations using a mapping towards the thermally induced aberrations.

The function, which may be non-linear and non-uniform, may represent the structural thermal deformation within the optical element and the resulting wavefront impact on the substrate.

The mapping towards the thermally induced aberrations may include ray tracing.

The method may further comprise using temperature measurements of the at least one optical element of the projection system for feedback correction of the estimated temperature distribution and the prediction of the thermally induced aberrations for at least one of thermal drift, thermal disturbances, modelling errors, changes in thermal boundary conditions and calibration errors.

This may provide robustness against drift over time. The temperature measurements may be used to estimate wavefront errors.

The thermal disturbances may be uncertainties in irradiation loads.

The modelling errors may be uncertainties in thermal model parameters.

The thermal drift may be (i) drift in the effective heat load by the EUV radiation and the associated off-band wavelengths generated in the EUV source (e.g. DUV and IR), (ii) drift in the IR laser and optics of the Optical element Heating control system, and/or (iii) drift in the heat transfer at the optical element surface due to pressure variations between the optical element and the projection system frame/vessel.

The temperature measurements may be real-time or sampled temperature measurements.

The method may further comprise using temperature measurements of the at least one optical element of the projection system for estimating the change of thermal boundary conditions of the at least one optical element, and estimating the temperature distribution and calculating the thermally induced aberrations of the projection system based on the estimation of the effect of thermal boundary conditions of the at least one optical element.

The temperature sensors may be located at or near to the mirror sides and backside.

The temperature sensors for estimating the effect of thermal boundary conditions may be in addition to the temperature sensors for feedback correction for the prediction of the thermally induced aberrations.

The thermal boundary conditions may be heat losses towards the environment.

The feedback correction may be based on the difference between the temperature measurements and estimated temperatures.

Feedback gain on the feedback correction may be determined in different ways, e.g. using a Kalman filter based on a thermal dynamic model.

The method may further comprise using temperature measurements of the at least one optical element of the projection system for estimating a mismatch between the irradiance profile for the at least one optical element and the actual irradiance profile, the irradiance profile being calculated independently of the characterisation of the patterning device and calculated using coefficients of a plurality of irradiance shapes, and estimating the temperature distribution and the thermally induced aberrations of the projection system based on the irradiance profile mismatch.

The characterisation of the patterning device may not be required to calculate the irradiance profile of the at least one optical element.

The temperature sensors may be located below the top surface of the optical element.

The temperature sensors for calculating the irradiance mismatch may be in addition to the temperature sensors for feedback correction for the prediction of the thermally induced aberrations.

The calculation of the coefficients may accommodate the irradiance profile mismatch.

The irradiance shapes and corresponding coefficients may be considered to be a disturbance model.

The irradiance shapes may be a fixed set.

There may be one temperature sensor per irradiance shape.

There may be one temperature sensor per segment covered by a single sector heater.

The method may further comprise using pressure measurements in the projection system for feedback correction for the estimation of the temperature distribution and the prediction of the thermally induced aberrations.

The pressure measurements may indicate pressure variations for the projection system, i.e. changes over time.

A pressure - heat transfer coefficient relation may be used to calculate the feedback correction.

The method may further comprise correcting thermally induced aberrations based on the predicted thermally induced aberrations in the projection system.

The correcting for the predicted thermally induced aberrations may include at least one of, translating and rotating at least one optical element, the patterning device, or a substrate, adapting the illumination source pupil setting, source mask optimization, changing the power of one or more sector heater or cooler, or adapting the shape of a deformable manipulator.

The at least one optical element may comprise a mirror or a lens.

The radiation beam may comprise an EUV radiation beam.

In accordance with a second aspect of the present invention, there is provided a system configured to predict thermally induced aberrations of a projection system for projecting a radiation beam, the system configured to: calculate an irradiance profile for at least one optical element of the projection system from a power and illumination source pupil of the radiation beam, estimate a temperature distribution as a function of time in the at least one optical element of the projection system using the calculated irradiance profile for the at least one optical element of the projection system; and calculate the thermally induced aberrations of the projection system based on the calculated temperature distribution and a thermal expansion map associated with the at least one optical element of the projection system, wherein the thermal expansion map is a spatial map indicating spatial variations of thermal expansion parameters in the at least one optical element of the projection system or a uniform map.

The system may comprise at least one temperature sensor for making temperature measurements of the at least one optical element of the projection system for feedback correction for the estimated temperature distribution and the prediction of the thermally induced aberrations for at least one of thermal drift, thermal disturbances, modelling errors, changes in thermal boundary conditions and calibration errors.

The at least one temperature sensor may comprise at least one of an optical element heating control temperature sensor, sector heater control temperature sensors, ambient temperature sensor, outlet and/or inlet cooling channel temperature sensor.

The system may be configured to correct for thermally induced aberrations associated with the projection system based on the predicted thermally induced aberrations in the projection system.

The at least one optical element may comprise a mirror or a lens.

According to a third aspect of the present invention, there is provided a lithographic apparatus comprising a projection system configured to project a radiation beam to project a pattern from a patterning device onto a substrate, wherein the lithographic apparatus comprises the system as described above.

According to a fourth aspect of the present invention, there is provided a computer program comprising computer readable instructions configured to cause a processor to carry out a method as described above.

According to a fifth aspect of the present invention, there is provided a computer readable medium carrying a computer program as described above.

According to a sixth aspect of the present invention, there is provided a computer apparatus comprising: a memory storing processor readable instructions; and a processor arranged to read and execute instructions stored in said memory; wherein said processor readable instructions comprise instructions arranged to control the computer to carry out a method as described above.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 depicts a schematic diagram of a projection system mirror heating model according to an embodiment of the invention;
- Figure 3 depicts a flow diagram of a method of predicting and correcting thermally induced aberrations in a projection system according to an embodiment of the invention.

### DETAILED DESCRIPTION

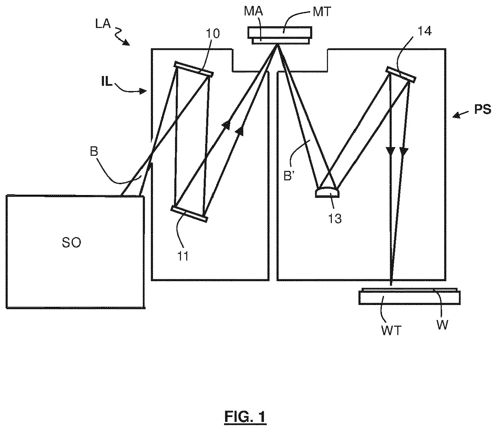

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

Optical surface deformation may occur in mirrors in the projection system PS of the EUV lithographic apparatus LA. It will be appreciated that, although the following description generally relates to a mirror or mirrors in the projection system PS in the EUV lithographic apparatus LA, the methods described are also applicable to other optical elements in the EUV lithographic apparatus LA and other optical elements in other lithographic apparatus, such as a DUV lithographic apparatus. For example, the optical element may be an mirror or a lens.

Exposure of the patterned EUV radiation beam causes typically highly non-uniform heating of the projection system mirrors, causing deformed optical mirror surfaces, resulting in wavefront errors affecting overlay, focus, and imaging performance.

To reduce the deformations causing aberrations in the projection system PS, the mirror material is optimized for minimum deformations using ultra-low expansion (ULE) material. This material exhibits a quadratic expansion relation with temperature, which has almost-zero expansion properties around its design temperature, known as the zero-crossing temperature (Tzc or ZCT). The mirror top side (the side which the radiation beam B' is incident upon) should be kept as close to this Tzc as possible to minimize deformations. Due to more aggressive heat loads (higher power, more extreme (i.e. more non-uniform) illumination profiles) it is not possible to keep the full mirror surface around this sweet spot. The mirror material may be made of other materials that have a relatively low or very low, coefficient of thermal expansion (CTE), e.g. ZERODUR or Cordierite. Optical surface deformation is very sensitive to the local (typically non-uniform) irradiance (heat load) and the (local) zero-crossing Temperature (Tzc).

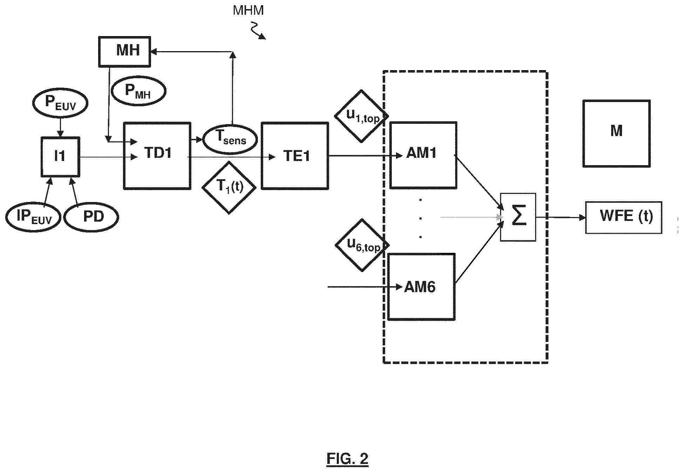

Figure 2 depicts a schematic diagram of a mirror heating model (MHM) for the projection system PS of the EUV lithographic apparatus LA. The mirrors of the projection system PS heat up as the EUV radiation beam B' pass through the projection system PS and the model predicts the resulting thermally induced aberrations of the projection system PS.

More particularly, the impact of thermal effects on the wavefront error (WFE) is sequentially build up from a number of sub-models. These models include a thermo-dynamic submodel (TD1), a thermo-elastic mapping sub-model (TE1), and a mapping towards aberrations submodel (AMI). The thermo-elastic mapping sub model (TE1) includes a spatial map (Tzc). The mapping towards aberrations sub-model (AMI) may include ray tracing.

The projection system PS may have six mirrors (M1-M6). Thus, the mirror heating model MHM has sub-models for each mirror M1-M6, i.e. TD1-TD6, TE1-TE6 and AM1-AM6. For clarity, Figure 2 only shows the sub-models TD1, TE1, AMI and AM6, but it will be understood that there are corresponding sub-models for all the mirrors M1-M6. Reference will be made to sub-models TD1, TE1 and AMI for mirror M1, but, it will be appreciated that, features described will be equally applicable to the sub-models of the other mirrors M2-M6. It will be appreciated that, in other embodiments, there may be more or less than 6 mirrors (or more generally optical elements) and, thus, more or less than the corresponding number of sub-models. In some embodiments, there may be a single optical element used in the mirror heating model (MHM).

The Tzc spatial map used in the sub-model TE1 may be calculated (or more particularly calibrated) in different ways. The Tzc spatial map indicates spatial variations of zero-crossing temperatures in the optical element. In other embodiments, the spatial map may be more generally considered to be a spatial map indicating spatial variations of thermal expansion parameters of the optical element (i.e. the mirror M1). In some embodiments, the spatial map may instead be a uniform map, i.e. a map without spatially varying thermal expansion parameters. More generally, there may be provided a thermal expansion parameter map for calculating the thermally induced aberrations of the projection system.

The thermo-mechanical properties may be calculated (calibrated) per mirror using temperature sensor tracing and laser powers from a mirror heating system MH. During operation of the EUV lithographic apparatus LA, the mirrors M1-M6 (in the projection system PS) may be exposed to EUV radiation. A heater may establish a constant or time-varying heat load to the mirrors M1-M6 irrespective of the presence and spatial distribution (illumination modes) of the EUV radiation.

Typically the EUV radiation is incident on different locations on the mirrors M1-M6 such that there is a spatially non-uniform heat load. The EUV radiation may be using a dipole illumination mode for example so that certain parts of the mirrors M1-M6 are not hit by EUV radiation. In addition, the EUV radiation may be on some of the time and off at other times.

Heaters may be used to heat the mirrors M1-M6 such that the spatial heat load distribution at the mirror surface is more, or relatively, stable over time. One particular spatial heat load distribution may be uniform, another spatial heat load distribution may be non-uniform. Some heaters may try to maintain the average temperature of the mirror's optical footprint, i.e. the part of the mirror's optical surface that in use receives and reflects EUV radiation, at some predefined value. In absence of any EUV radiation the temperature would be uniform inside the footprint, which in view of boundary conditions requires a spatially non-uniform irradiance. This mirror heating tries to control the average temperature of an optical footprint of the mirrors M1-M6 to minimize aberrations. The heaters may be IR heaters so that the radiation will not affect the imaging on the substrate W. It will be appreciated that there may be a plurality of heaters and there may be one or a plurality of heaters for each mirror or, more generally, each optical element.

The mirror heating model MHM also includes an Imaging submodel I1. The output from the sub-model I1 is an irradiance profile of the mirror M1. Inputs into the imaging model I1 may be power of the EUV radiation beam (P_{EUV}) (including whether it is switched on or off), an illumination profile of the EUV radiation beam (IP_{EUV}), and a characterization PD of a patterning device MA. The characterization PD of the patterning device MA may be considered to be a pattern of the patterning device MA. In some embodiments, the characterization PD of the patterning device MA may not be required, as will be explained.

The sub-model I1 may comprise a plurality of optical models. A diffracted pattern at the patterning device level may be obtained with imaging simulations. This may be an outcome of source mask optimization based on computational modelling. The diffracted pattern at the patterning device MA may be calculated using the illumination source pupil and the pattern of the patterning device MA using an optical model in the sub-model I1. The diffracted pattern at the pattering device MA may be used to calculate the irradiance profile at the mirror M1. This may be by using another optical model in the sub-model I1.

The irradiance profile of the mirror M1 may provide a diffraction based estimate of the heat load on the mirror M1 of the projection system PS. The irradiance profile of the mirror M1 may be considered to be an irradiance pattern on the mirror M1.

Thermal measurements of the mirror M1 may be used as inputs into the thermal model TD1. The thermal measurements may be from thermal sensors (i.e. temperature sensors). The thermal measurements may comprise heat absorption, conduction, convection, or radiation.

Inputs into the sub-model TD1 include power of the mirror heating system (P_{MH}), the calculated irradiance profile of the mirror M1 from the imaging sub-model I1, and temperatures of sensors (Tₛₑₙₛ), e.g. via the MH feedback control. Thus, for thermo-dynamic identification (single mirror), T₁(t) (or more generally Tᵢ(t)) is found using P_{MH}, P_{EUV}, IP_{EUV}, PD and Tₛₑₙₛ. The temperature sensors may be located on or below the surface of the mirror M1.

The submodel TD1 describes the transient temperature distribution in mirror M1, including MH feedback control. Each mirror M1-M6 may be described by a thermal Finite Element Model (FEM) based on first principles of the actual mirror geometries. In other embodiments, the submodel TD1 may comprise different types of models, such as an empirical model.

The full state thermal footprint (i.e. temperature distribution) of each mirror as a function of time T(t) may be determined. The thermal footprint may be the 3D thermal state, i.e. the temperature at each location in the mirror at a given time instant. In other words, it is the 3D temperature distribution within the mirror or mirrors as a function of time. More generally, a temperature distribution in the mirror (optical element) is calculated as a function of time using the sub model TD1. For mirror 1 (M1), the full state thermal footprint is T₁(t).

The full state thermal footprint T₁(t) is input into the sub-model TE1.

The submodel TE1 may be a non-linear static mapping of the non-linear and non-uniform relation between temperatures to structural strain, parameterized by a spatial Zero Crossing Temperature (ZCT) per mirror position, which may vary in a typical range of several Kelvins within each mirror M1-M6. The relation from strain to structural deformation may be described by a mechanical FEM model.

An expression for the thermal expansion sub-model TE1 may be L(T₁(t), T_{zc,i}(p)) , where L indicates a non-linear function, T₁(t) is the thermal footprint of mirror M1 as a function of time and T_{zc,i}(p) is the thermal-elastic mapping.

The output from the sub-model TE1 is an indication of the deformation of the top surface of the mirror (u₁,ₜₒₚ). The top surface being the surface which the EUV radiation beam is reflected from. The output (u₁,ₜₒₚ - u₆,ₜₒₚ) from each of the sub-models TE1-TE6 for each mirror M1-M6 are input into the sub-models AM1-AM6.

The model AMI may comprise a linear static mapping that describes the contribution of the deformed optical surface of the mirror M1 to the total (mirror-heating-induced) wavefront error of the projection system PS.

The sub-models AM1-AM6 simulate radiation beam ray tracing and the results for each of the mirrors M1-M6 are combined (summed) to provide a wavefront error over time (WFE(t)) for all the mirrors M1-M6. That is, wavefronts are simulated and wavefront errors WFE(t) are taken from the simulated wavefronts aberrations. It will be appreciated that, in other embodiments, a wavefront error WFE(t) may be calculated for more or less than 6 mirrors. For example, the wavefront error WFE(t) (or more generally optical measurement error) may be calculated in a heating model for a single mirror (or more generally, a single optical element).

Wavefront error (WFE) indicates deformation / temperature per mirror i (e.g. M1-6). Wavefront error (WFE) may be expressed as: ***WFE*(t)** = ∑*ᵢ^{mirrors}Mᵢuᵢ,ₜₒₚ*= ∑*ᵢ^{mirrors}Mᵢ Lᵢ* (*Tᵢ*(t),*Tᵢ,_{zc}*(*p*))·*T*ᵢ(**t**), where Mᵢ is the mirrors (e.g. M1-M6), Tᵢ is the temperature field, and a summation is taken over all the mirrors Mᵢ.

The spatial map is used in the sub-model TE1, in combination with the sub-models I1, TD1 and AMI, to provide the simulated wavefronts without requiring actual wavefront measurements to be measured by an optical measurement apparatus.

Real time computation may be enabled due to a fast solver for real-time simulation of the MHM of Figure 2, which may be used to model sufficient thermal states e.g. 1000, 10000 or 100000 per mirror) and compute its non-linear mapping to wavefront errors. Furthermore, calibration may be enabled using a calibration method for the spatially non-uniform ZCT, which may be an important contributor to model errors. The calibration may be in real time but this is not typical.

A different model (i.e. an empirical prediction model) may have been used to predict thermally induced aberrations. However, the empirical model may have accuracy limitations, therewith affecting imaging, overlay, and focus performance. In addition, it may have required a new calibration per customer application, therewith affecting productivity.

A problem with an empirical model is that it may require a relatively lengthy calibration for each application to characterize the thermal dynamic behaviour at time scales from seconds to hours, whereas the (non-linear & non-uniform) thermo-elastic behaviour depends on which parts of the optical elements heat up.

The MHM of Figure 2 uses temperature sensors and/or wavefront measurements for robustness against drift. The MHM predicts the wavefront difference w.r.t. the previous wavefront measurement. So the reference, i.e., previous measurement, changes with each new measurement. The MHM uses real-time temperature measurements to correct for (i) thermal drift and for (ii) modelling and calibration errors. A feedback correction to the MHM to predict the temperature distribution and thermally induced aberrations of the projection system PS is made on the difference between the true measured temperatures at temperature sensor locations and the estimated temperatures thereof. The feedback gain on this estimation error can be designed in different manners, e.g., a Kalman filter balances the model-based prediction with the measurement (including noise).

More generally, the MHM of Figure 2 uses temperature measurements of the mirror M1 of the projection system PS for feedback correction for the prediction of thermally induced aberrations in the projection system PS. Different temperature sensors may be used to provide the temperature measurements.

For example, the same temperature sensors can be used as may be used for MH control. These may be integrated in the structure of certain projection system mirrors, e.g. about 1 to 10 millimetre below the optical surface. For mirrors without MH, then additional temperature sensors may be used.

As another example, for mirrors with a sector heater, the -10 temperature sensors associated to each heater segment for sector heater control may be used. This may enable more disturbance sources to be distinguished and hence may enable higher accuracy.

As a further example, for mirrors with water cooling, a temperature sensor at the cooling channel outlet (and inlet) may be used to avoid the manufacturing difficulty of producing both cooling channels and temperature sensors a few mm below the optical surface. Segmentation of cooling water channels can be considered to enable temperature sensing of individual mirror segments.

Another problem with the empirical model may be that it was sensitive on the longer time scale to thermal drift such as (i) drift in the effective heat load by EUV and the associated off-band wavelengths generated in the EUV Source (i.e., DUV and IR); (ii) drift in the IR laser and optics of the Mirror Heating (MH) control system; and (iii) drift in the heat transfer at the mirror surfaces due to pressure variations between the mirror and the POB (projection optics box) frame/vessel. An advantage of the MHM of Figure 2 with thermal measurement feedback may be that thermal drift may be suppressed. This may improve the tracking of thermal history. Furthermore, this may avoid the need for frequent calibrations, i.e. reduce the number of calibrations required.

The temperature sensors are used to feedback into the MHM of Figure 2. Thus, the temperature sensors may be used to estimate wavefront errors (between wavefront measurements).

In addition, wavefront measurements M may be measured by an optical measurement apparatus.

The optical performance of the mirror heating model MHM including the Tzc spatial maps may be matched with measured data from wavefront measurements.

Wavefront errors WFE (nm) over time (t) may be shown for different Zernikes, i.e. Z₂ to Z₂₅. Thermally induced aberrations may, for example, be expressed as a set of Zernikes. For example, Zernike coefficients Z₅ to Z₂₅ may be used to express the aberrations. In other examples, other ranges of Zernike coefficients may be used. For example Zernike coefficients from Z₂, up to Z₆₄, up to Z₇₇, or up to Z₁₀₀ may be used.

Measurements may be taken at several different positions within the exposure slit (e.g. 3, 7 or 13) in an optical measurement apparatus.

For some lithographic apparatus LA, wavefront error measurements (expressed in Zernikes) may become available from after each lot. Subsequently, these errors may be compensated by lens corrections, by adjusting the orientation of the projection system PS mirrors and/or stages.

For other lithographic apparatus LA, similar compensations are targeted, but they may be upon every wafer (substrate) instead of upon every lot, by using wavefront error measurements from a faster optical measurement apparatus. This per wafer lens correction may be called "inter-wafer lens correction."

For other lithographic apparatus, it may be desired to also compensate for wavefront errors caused by relatively fast mirror heating effects within one wafer, so in between wavefront measurements, by using "stepping projection system PS mirrors" that can be adjusted in between the exposures of subsequent fields. Such per field (or per set of fields) lens correction may be called "intra-wafer lens correction." Because the actual wavefront errors may only be measured by the optical measurement apparatus per wafer (not per field), for intra-wafer lens correction it may be beneficial to use model-based estimations of the wavefront errors.

It may be shown that intra-wafer correction gives a significant improvement compared to inter-wafer lens correction, especially for the first wafer in the lot. This solution improves the performance of the lithographic apparatus LA significantly, even at intra-wafer time scale. In addition, it may be shown that tracking thermal history is important.

The MHM of Figure 2 may be considered to be a physical model. The MHM tracks the thermal history, until it is switched off, so it is important not to switch of or reset the model states between applications.

It may be shown that the physical model combined with temperature feedback (e.g. using a Kalman filter) outperforms the feedforward (physical) model, especially for the feedforward model without thermal history, but also for the feedforward model with thermal history. This is especially the case for the first wafer. For a case with thermal history, the usage of the temperature sensors in the Kalman filter reduces lithographic apparatus performance errors compared to a case without temperature feedback. The temperature feedback in the Kalman filter also results in a better robustness against model errors in the HTC (heat transfer coefficient) parameters. The added sensor feedback is an effective means to compensate for inevitable modelling errors (like uncertainties in thermal model parameters) and neglected disturbances (like uncertainties in irradiation loads).

The predicted thermally induced aberrations may be corrected in the lithographic apparatus LA. Depending on the type of optical element, this may be by, e.g. translating and rotating at least one optical element (e.g. mirror or lens), the patterning device, or a substrate, adapting the illumination source pupil setting and changing the power of a sector heater or a cooler, or adapting the shape of a deformable manipulator. In the case of adaptive illumination, source mask optimization may also be used. Source mask optimization relates to changing illumination patterns and placing assist features in the mask to enhance lithographic performance. The heater(s) may comprise infrared heater(s) or resistance wire(s) that for example may be embedded in the optical element. The cooler(s) may comprise water or gas. The deformable manipulator(s) may comprise a piezoelectric actuator in an optical element, a patterning device clamp, a substrate clamp, or a substrate table.

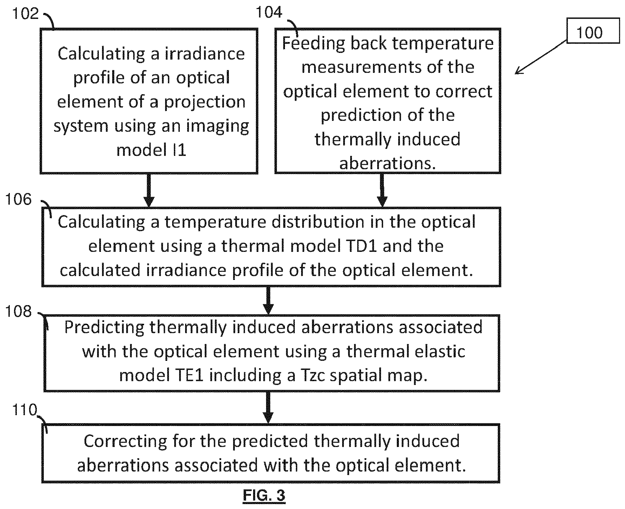

Figure 3 depicts a flow diagram 100 of a method of predicting and correcting thermally induced aberrations of the projection system PS. That is, predicting, and correcting for, thermally induced aberrations associated with an optical element or optical elements of a projection system PS in a lithographic apparatus LA.

In step 102, a irradiance profile of the optical element is calculated using an imaging model I1.

In step 104, temperature measurements of the optical element are fed back, e.g. via the MH feedback control, into a thermal model TD1, to correct the prediction of the thermally induced aberrations. The temperature measurements may be taken by one or more temperature sensors. The temperature measurements may be fed back via a filter (e.g. a Kalman filter) to correct the temperature distribution.

In step 106, the temperature distribution (i.e. a thermal footprint) in the optical element is calculated using the thermal model TD1 and the calculated irradiance profile of the optical element.

In step 108, thermally induced aberrations associated with the optical element are predicted using a thermal elastic model TE1 including a Tzc spatial map.

In step 110, a correction is or corrections are made for the predicted thermally induced aberrations associated with the optical element. This correction or these corrections may include at least one of, moving at least one optical element, radiation source and patterning device optimization, and controlling a heater, a cooler, or a deformable manipulator.

The main input of the MHM of Figure 2 (i.e. the input to the submodel I1) is an estimate of the diffracted pattern at reticle (patterning device MA) level. The diffracted pattern may be computed with the source pupil, which is the illuminator setting available in the lithographic apparatus LA, and with the mask (patterning device MA) pattern. The pattern of the patterning device MA may be confidential information and so using this information may require a secure infrastructure between ray tracing software and the lithographic apparatus LA, which may be feasible but may be relatively complex. The pattern of the patterning device MA may, more generally, be considered to be a characterization of the patterning device MA. The MHM of Figure 2 (more particularly submodel I1) may then compute the irradiance pattern per optical element using an optical model.

The MHM of Figure 2 uses temperature sensor measurements to estimate the temperature distribution in each mirror M1-M6. In some embodiments, the MHM may be provided with an accurate estimate of the diffraction pattern, which is patterning device MA dependent. However, in other embodiments, temperature measurements of the mirror M1 may be used for estimating a mismatch between the irradiance profile for the mirror M1 and the actual irradiance profile. This means that the information of the patterning device MA, (i.e. the characterisation of the patterning device MA) may not be required. In this case, the irradiance profile of the mirror M1 may be calculated independently of the characterisation of the patterning device MA. The characterisation of the patterning device MA may not be required to calculate the irradiance profile of the mirror M1. The thermally induced aberrations of the projection system PS may be based on the estimation of the irradiance profile mismatch.

The temperature measurements may be made using the temperature sensors used to estimate the temperature distribution (i.e. the temperature feedback into the submodel TD1 mentioned above) or additional temperature sensors. The temperature sensors for the irradiance profile mismatch estimation may be located below the top surface of the mirror M1. The purpose determines where the sensors are preferably located: e.g. near the top surface of the mirror M1 to better estimate the irradiance and near the mirror sides to better estimate the conduction towards the ambient.

To reconstruct the irradiance profile mismatch, the MHM of Figure 2 may be augmented with a disturbance model such that a augmented MHM is provided. This disturbance model may comprise a fixed set of irradiance shapes and corresponding coefficients. During operation, the augmented MHM may estimate these coefficients besides the temperature distribution of the mirror M1, in order to accommodate for the irradiance profile mismatch. As such, the fixed set of irradiance shapes in the disturbance model may be designed such that a wide range of use-case dependent irradiance profile mismatches can be approximated by a linear combination of these shapes. The number of shapes in the disturbance model may be limited by the number of available sensors.

A projection system PS mirror may have sector heater/sensor segmentation (e.g. with 10 sensors). The mirror may have one temperature sensor per segment. This may be shown to be a suitable choice for the fixed set of irradiance shapes in the disturbance model.

It may be shown that the (additional) temperature sensors, to estimate the mirror irradiance, and the augmented model MHM, to enable reconstruction of irradiance mismatch caused by diffraction, is beneficial for optical performance, in case patterning device MA information is not used in the estimation model. More particularly, it may be shown that these temperature sensors (e.g. extra temperature sensors) may replace the requirement for patterning device MA information.

The heat transfer coefficients of the sides and backside of the mirrors M1-M6 of the projection system PS are sensitive to pressure variations in the projection system PS. For some lithographic apparatus LA, the pressure may be expected to be stable within +/- -5% (0.2 Pa), which may be able to be corrected with the earlier proposed temperature sensor feedback. However, a much larger pressure range of roughly >10 times may be required to be supported to deal with: usage with and without a pellicle, lithographic apparatus flow configuration changes, source in-flow changes, and turbo molecular pump failures. It may be shown that this provides a significant performance impact.

The Heat Transfer Coefficient (HTC) sensitivity to pressure may be shown. In near vacuum, the Heat Transfer Coefficient (HTC) is a function of pressure and distance to the environment (i.e., POB frames), which can be described by the Sherman-Lees equation. The heat transfer coefficient is sensitive to pressure at relatively small gaps (<10 mm) between the mirror and its environment, for the given POB pressure of 1 - 10 Pa.

In some embodiments, pressure measurements may be taken in the projection system PS for feedback correction for the prediction of the thermally induced aberrations. That is, pressure variations within the POB may be measured and fed back into the MHM of Figure 2 (i.e. the physical model), using the pressure - heat transfer coefficient relation, e.g. using a model based on first principles. The pressure measurements may indicate pressure variations for the projection system PS, i.e. changes over time. For example, the HTC during production may differ from that during calibration. In this way, the pressure variation in the projection system PS may be compensated for. The pressure feedback for the MHM of Figure 2 or augmented MHM may improve the accuracy of the estimate of wavefront errors for intra-wafer correction and for wavefront-based sector heater control.

Thermal boundary conditions, i.e., conduction and radiation, are model components with large uncertainties. Besides the pressure, the effective HTC is dependent on: temperature of the surrounding material, surface conditions of both the mirror M1 and surrounding material subject to contamination, radiative heat transfer as a function of surface-dependent emissivities and view factors.

These uncertainties may not be able to be determined from pressure feedback, but can be substantially reduced by measuring the temperatures of the mirror M1 back and side surfaces, e.g., using the augmented MHM as described above. More generally, temperature measurements of the mirror M1 may be used for estimating an effect of thermal boundary conditions of the mirror M1. This may make the wavefront error estimation independent of the thermal boundary conditions uncertainties.

The temperature measurements may be made using the temperature sensors used to estimate the temperature distribution (i.e. the temperature feedback into the submodel TE1 mentioned above), the temperature sensors for calculating the irradiance mismatch or additional temperature sensors. The temperature sensors for estimating the effect (i.e. change) of the thermal boundary conditions may be at or near the mirror sides and/or backside (e.g. between 1-30mm).

It may be shown that pressure feedback of the MHM of Figure 2 or the augmented MHM, or extra temperature sensors at the mirror boundaries, to better estimate the heat transfer coefficients at the mirror boundaries may reduce the effect of HTC variation in the estimation methods. More particularly, it may be shown that these temperature sensors (e.g. extra temperature sensors) and/or pressure feedback may solve the pressure range problem.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of predicting thermally induced aberrations of a projection system for projecting a radiation beam, the method comprising:
calculating an irradiance profile for at least one optical element of the projection system from a power and illumination source pupil of the radiation beam ,
estimating a temperature distribution as a function of time in the at least one optical element of the projection system using the calculated irradiance profile for the at least one optical element of the projection system;
calculating the thermally induced aberrations of the projection system based on the estimated temperature distribution and a thermal expansion parameter map associated with the at least one optical element of the projection system, wherein the thermal expansion parameter map is a spatial map indicating spatial variations of thermal expansion parameters in the at least one optical element of the projection system or a uniform map.

2. The method of claim 1, further comprising calculating the irradiance profile using a diffracted pattern of the radiation beam at a patterning device, the projection system projecting radiation from the patterning device.

3. The method of claim 2, further comprising calculating the diffracted pattern using the power of the radiation beam, the illumination source pupil of the radiation beam and a characterization of the patterning device.

4. The method of either one of claims 2 or 3, further comprising calculating the diffracted pattern using an optical model based on first principles.

5. The method of any one of the preceding claims, further comprising calculating the temperature distribution using linear or non-linear differential equations.

6. The method of any one of the preceding claims, further comprising estimating the temperature distribution using a thermal dynamic model based on first principles.

7. The method of any one of the preceding claims, further comprising calculating the thermally induced aberrations using a static non-linear function, calculating structural strain in the at least one optical element of the projection system from the estimated temperature distribution, calculating the thermally induced aberrations of the projection system based on the calculated structural strain in the at least one optical element of the projection system, calculating structural deformation of the at least one optical element of the projection system using the calculated structural strain and calculating the thermally induced aberrations of the projection system using the calculated structural deformation of the at least one optical element of the projection system, and calculating the thermally induced aberrations using a mapping towards the thermally induced aberrations.

8. The method of any one of the preceding claims, further comprising using temperature measurements of the at least one optical element of the projection system for feedback correction of the estimated temperature distribution and the prediction of the thermally induced aberrations for at least one of thermal drift, thermal disturbances, modelling errors, changes in thermal boundary conditions and calibration errors.

9. The method of claim 8, wherein the temperature measurements are real-time or sampled temperature measurements.

10. The method of either one of claims 8 or 9, further comprising using temperature measurements of the at least one optical element of the projection system for estimating a change of thermal boundary conditions of the at least one optical element, and estimating the temperature distribution and calculating the thermally induced aberrations of the projection system based on the estimation of the effect of thermal boundary conditions of the at least one optical element.

11. The method of any one of claims 8-10, wherein the feedback correction is based on the difference between the temperature measurements and estimated temperatures.

12. The method of any one of claims 8-11, further comprising using temperature measurements of the at least one optical element of the projection system for estimating a mismatch between the irradiance profile for the at least one optical element and the actual irradiance profile, the irradiance profile being calculated independently of the characterisation of the patterning device and calculated using coefficients of a plurality of irradiance shapes, and estimating the temperature distribution and the thermally induced aberrations of the projection system based on the irradiance profile mismatch.

13. The method of any one of the preceding claims, further comprising using pressure measurements in the projection system for feedback correction for the estimation of the temperature distribution and the prediction of the thermally induced aberrations.

14. The method of any one of the preceding claims, further comprising correcting thermally induced aberrations based on the predicted thermally induced aberrations in the projection system.

15. The method of claim 14, wherein the correcting for the predicted thermally induced aberrations includes at least one of: translating and rotating at least one optical element, the patterning device, or a substrate, adapting the illumination source pupil setting, source mask optimization, changing the power of one or more sector heater or cooler, or adapting the shape of a deformable manipulator.

16. The method of any one of the preceding claims, wherein the at least one optical element comprises a mirror or a lens.

17. The method of any one of the preceding claims, wherein the radiation beam comprises an EUV radiation beam.

18. A system configured to predict thermally induced aberrations of a projection system for projecting a radiation beam, the system configured to:
calculate an irradiance profile for at least one optical element of the projection system from a power and illumination source pupil of the radiation beam,
estimate a temperature distribution as a function of time in the at least one optical element of the projection system using the calculated irradiance profile for the at least one optical element of the projection system; and
calculate the thermally induced aberrations of the projection system based on the calculated temperature distribution and a thermal expansion parameter map associated with the at least one optical element of the projection system, wherein the thermal expansion parameter map is a spatial map indicating spatial variations of thermal expansion parameters in the at least one optical element of the projection system or a uniform map.

19. The system of claim 18, wherein the system comprises at least one temperature sensor for making temperature measurements of the at least one optical element of the projection system for feedback correction for the estimated temperature distribution and the prediction of the thermally induced aberrations for at least one of thermal drift, thermal disturbances, modelling errors and calibration errors.

20. The system of claim 19, wherein the at least one temperature sensor comprises at least one of an optical element heating control temperature sensor, sector heater control temperature sensors, ambient temperature sensor, outlet and/or inlet cooling channel temperature sensor.

21. The system of any one of claims 18-20, wherein the system is configured to correct for thermally induced aberrations associated with the projection system based on the predicted thermally induced aberrations in the projection system.

22. The system of any one of claims 18-21, wherein the at least one optical element comprises a mirror or a lens.

23. A lithographic apparatus comprising a projection system configured to project a radiation beam to project a pattern from a patterning device onto a substrate, wherein the lithographic apparatus comprises the system of any one of claims 18-22.

24. A computer program comprising computer readable instructions configured to cause a processor to carry out a method according to any one of claims 1 to 17.

25. A computer readable medium carrying a computer program according to claim 24.

26. A computer apparatus comprising:
a memory storing processor readable instructions; and
a processor arranged to read and execute instructions stored in said memory;
wherein said processor readable instructions comprise instructions arranged to control the computer to carry out a method according to any one of claims 1 to 17.
